# EUROPEAN PATENT SPECIFICATION

(11) **EP 1 840 937 B1**
(45) Date of publication and mention of the grant of the patent: **07.05.2014**
(21) Application number: 07006722.8
(22) Date of filing: 30.03.2007
(51) Int. Cl.: H01J 37/32

(54) **Plasma processing apparatus and plasma processing method**
Gerät und Verfahren zur Plasmabehandlung
Appareil et procédé de traitement par plasma

(30) Priority: 30.03.2006 JP 2006092908
(43) Date of publication of application: 03.10.2007
(73) Proprietor: TOKYO ELECTRON LIMITED, Minato-ku Tokyo 107-8481 (JP)
(72) Inventor: Matsumoto, Naoki, Tokyo 107-8481 (JP); Koshimizu, Chishio, Tokyo 107-8481 (JP); Hayakawa, Yoshinobu, Tokyo 107-8481 (JP); Hanaoka, Hidetoshi, Tokyo 107-8481 (JP); Iwata, Manabu, Tokyo 107-8481 (JP); Tanaka, Satoshi, Tokyo 107-8481 (JP)
(74) Representative: HOFFMANN EITLE

(56) References cited:
- WO-A-03/003405
- US-A1- 2006 037 703
- US-A1- 2006 037 704

## Description

The present invention relates to a technique for performing a plasma processing on a target substrate; and, more particularly, to a capacitively coupled plasma processing apparatus of a dual frequency application mode and a plasma processing method.

In a manufacturing process of semiconductor devices or flat panel displays (FPDs), a plasma is used to perform a processing, such as etching, deposition, oxidation, sputtering or the like, so as to obtain a good reaction of a processing gas at a relatively low temperature. Conventionally, a capacitively coupled type plasma apparatus has been widely employed as a single-wafer plasma processing apparatus, especially, as a single-wafer plasma etching apparatus.
Generally, in the capacitively coupled plasma processing apparatus, an upper electrode and a lower electrode are disposed to face each other in parallel in a vacuum processing chamber, a substrate to be processed (a semiconductor wafer, a glass substrate or the like) is mounted on the upper electrode, and a radio frequency voltage is applied to either one of the upper and the lower electrode. Electrons are accelerated by an electric field formed by the radio frequency voltage to collide with a processing gas. As a result of ionization by the collision between the electrons and the processing gas, a plasma is generated, and a desired microprocessing (for example, etching) is performed on the surface of the substrate by radicals or ions in the plasma. At this time, the electrode to which the radio frequency voltage is applied is connected with a radio frequency power supply via a blocking capacitor in a matching unit and thus serves as a cathode. A cathode coupling method in which the radio frequency voltage is applied to the lower electrode, serving as the cathode, for supporting the substrate enables an anisotropic etching by substantially vertically attracting ions in the plasma to the substrate with a self-bias voltage generated in the lower electrode.
In the capacitively coupled plasma processing apparatus of the dual frequency application type, a first radio frequency power of a relatively radio frequency (generally, 27 MHz or greater) for plasma generation and a second radio frequency power of a relatively low frequency (generally, 13.56 MHz or less) for ion attraction are applied to the lower electrode (see, e.g., Japanese Patent Laid-open Publication No. 2000-156370 and U.S. Patent No. 6,642,149).
The dual frequency application is advantageous in that plasma density and anisotropic etching selectivity can be individually optimized by the first and the second radio frequency power, and also in that the second radio frequency power of a relatively low frequency can effectively prevent or suppress a deposit adhesion during a process in which deposits such as polymer and the like are adhered to an upper electrode. Specifically, when the ions are incident on the upper electrode serving as an anode, a deposited film (and an oxide film, if it exists) adhered to the electrode is sputtered by ion impact. The number of ions used for the sputtering is determined by the first radio frequency. Further, an electric field that accelerates the ions is generated by the second radio frequency power of the relatively low frequency.

In the conventional capacitively coupled plasma processing apparatus of the dual frequency application type as described above, the upper electrode serving as the anode to which no radio frequency is applied is DC-grounded generally. Typically, a processing chamber, which is frame grounded, is formed of metal, e.g., aluminum, a stainless steel or the like, so that the upper electrode can be held at ground potential via the processing chamber. Accordingly, the upper electrode is directly attached to a ceiling of the processing chamber to be integrally assembled thereto or the ceiling of the processing chamber itself is used as the upper electrode.
With a recent trend of miniaturization of design rules for the manufacturing process, a high-density plasma is required to be available at a low pressure for a plasma processing. In the capacitively coupled plasma processing apparatus in which dual frequency powers are applied to the lower electrode, the frequency of the first radio frequency power, which mainly contributes to a plasma generation, tends to be gradually increased and a frequency of 40 MHz or greater is standardly used in recent years. However, if the frequency of the radio frequency power becomes high, a radio frequency current is made to be concentrated on a central portion of the electrode, so that a density of a plasma generated in a processing space between two electrodes becomes higher at the central portion of the electrode than that at the edge portion thereof. As a result, there occurs a problem that process characteristics become nonuniform in a radial direction. Meanwhile, since the frequency of the second frequency power that mainly contributes to ion attraction is relatively low, it is not focused on the central portion of the electrode. In other words, in the conventional apparatus in which the upper electrode is directly attached to or formed integral with the processing chamber to be DC-grounded therethrough, the functions of the second radio frequency power that include attracting the ions toward the substrate and suppressing the deposit adhesion to the upper electrode are not deteriorated.

In US 2006/0037704 A1 there is disclosed a plasma processing apparatus for processing a substrate by using a plasma which includes a processing chamber for accommodating and processing the substrate, a lower electrode for mounting the substrate thereon in the processing chamber, an upper electrode disposed to face the lower electrode in the processing chamber, a radio frequency supply for supplying a radio frequency power to at least one of the lower and upper electrodes, to thereby generate the plasma between the lower and upper electrodes, and an electrical characteristic control unit for adjusting an impedance of a circuit at the side of an electrode to the plasma for a frequency of at least one radio frequency wave present in the processing chamber such that the circuit does not resonate.

In WO 03/003405 there is disclosed a method and apparatus for controlling a bias voltage over a wide range and for de-coupling dual radio frequency currents to allow for independent control of plasma density and ion energy of a plasma for processing a substrate. The apparatus may provide a plasma processing chamber which includes a bottom electrode configured to hold a substrate and first and second radio frequency power supplies connected to the bottom electrode. There is a top electrode which is electrically isolated from a top ground extension. A filter array defining a set of filter settings is included. A switch is coupled to the top electrode and the switch is configured to interconnect the top electrode to one of the filter settings. The filter settings are configured to enable or disable radio frequency current generated from one or both of the radio frequency power supplies from passing through the top electrode.

It is, therefore, an object of the present invention to provide a capacitively coupled plasma processing apparatus and method of a dual frequency application type in which two kinds of radio frequency powers are applied to an electrode for supporting a target substrate thereon, wherein in-surface uniformity of processes can be improved by controlling plasma density spatial distribution characteristics while preventing or suppressing an undesired film from being formed on another electrode facing the electrode for supporting the target substrate.

In accordance with a first aspect of the invention, there is provided a plasma processing apparatus according to claim 1.

In accordance with a second aspect of the invention, there is provided a plasma processing method according to claim 11.

According to the disclosure, an equivalent circuit in a radio frequency transmission line from the boundary surface between the processing space and the first electrode to the ground potential via the first electrode is configured as a serial-parallel LC circuit. In this serial-parallel LC circuit, an impedance extremely decreases at a specific frequency (resonance frequency) and extremely increases at another specific frequency (antiresonance frequency). By utilizing those characteristics, a high impedance and a low impedance can be obtained at the first and the second radio frequency, respectively. The resonance frequency is obtained within a range from about 0.1 kHz to about 15 MHz and the antiresonance frequency is obtained within a range from about 5 MHz to about 200 MHz in the frequency-impedance characteristics of the equivalent circuit or the serial-parallel LC circuit. By optimally increasing the impedance at the first radio frequency in the serial-parallel LC circuit, plasma density spatial distribution characteristics can be controlled to be uniform diametrically. Further, by decreasing the impedance at the second radio frequency in the serial-parallel LC circuit substantially to a level at which a short-circuit occurs, the sputtering effect of removing an undesired film from the surface of the first electrode can be further enhanced.

In the plasma processing apparatus in accordance with the first aspect of the present invention, a desired DC voltage is applied from the DC power supply to the first electrode via the filter to obtain acting effects thereby. Further, the functions of the first and the second radio frequency can be corrected, controlled or assisted by the frequency-impedance characteristics of the filter. For example, when the filter is provided in the serial-parallel LC circuit as in the second plasma processing apparatus, it is possible to improve the plasma density spatial distribution characteristics or the sputtering effect for the first electrode (which removes an undesired film therefrom).
In accordance with the plasma processing apparatus and the plasma processing method of the present invention, it is possible to resolve a tradeoff in the functions of the first and the second radio frequency in the capacitively coupled apparatus of a dual frequency application type (wherein two radio frequency powers are applied to an electrode) with the above-described configurations and operations. Especially, the in-surface uniformity of processes can be improved by controlling the plasma density spatial distribution characteristics while preventing or suppressing an undesired film from being formed on the other electrode facing the electrode to which two radio frequency powers are applied.

The above and other objects and features of the present invention will become apparent from the following description, given in conjunction with the accompanying drawings, in which:
Fig. 1 is a vertical cross sectional view of a plasma etching apparatus in accordance with an example;
Fig. 2 schematically shows a capacitively coupled radio frequency discharge system in a plasma etching apparatus of a comparative example;
Fig. 3 schematically illustrates a capacitively coupled radio frequency discharge system in the plasma etching apparatus shown in Fig. 1;
Fig. 4 describes an example of frequency-impedance characteristics in a radio frequency transmission line to a ground potential via an upper electrode in the plasma etching apparatus shown in Fig. 1;
Fig. 5A depicts in-surface distribution characteristics of an etching rate of an oxide film in a test example;
Fig. 5B presents in-surface distribution characteristics of an etching rate of a photoresist in the test example;
Fig. 6A represents in-surface distribution characteristics of an etching rate of an oxide film in a first comparative example;
Fig. 6B describes in-surface distribution characteristics of an etching rate of a photoresist in the first comparative example;
Fig. 7A offers in-surface distribution characteristics of an etching rate of an oxide film in a second comparative example;
Fig. 7B provides in-surface distribution characteristics of an etching rate of a photoresist in the second comparative example;
Fig. 8 illustrates a vertical cross sectional view of a plasma etching apparatus in accordance with an embodiment of the present invention;
Fig. 9 is a circuit diagram showing an exemplary configuration of a circuit in a DC filter unit of the plasma etching apparatus;
Fig. 10 depicts an example of frequency-impedance characteristics of a serial-parallel LC circuit in the DC filter unit and an example of frequency-impedance characteristics in a radio frequency transmission line to a ground potential via an upper electrode in the plasma etching apparatus shown in Fig. 2;
Fig. 11 shows a circuit diagram of a modified configuration of the circuit in the DC filter unit;
Fig. 12 sets forth a circuit diagram of a modification of the serial-parallel LC circuit ;
Fig. 13 describes a fragmentary cross sectional view of an example of a capacitance varying unit in the plasma etching apparatus in accordance with the embodiment of the present invention;
Fig. 14 offers a fragmentary cross sectional view of another example of the capacitance varying unit in the plasma etching apparatus in accordance with the embodiment of the present invention;
Fig. 15 presents a fragmentary cross sectional view of still another example of the capacitance varying unit in the plasma etching apparatus in accordance with the embodiment of the present invention; and
Fig. 16 represents a vertical cross sectional view of a plasma etching apparatus in accordance with an example.

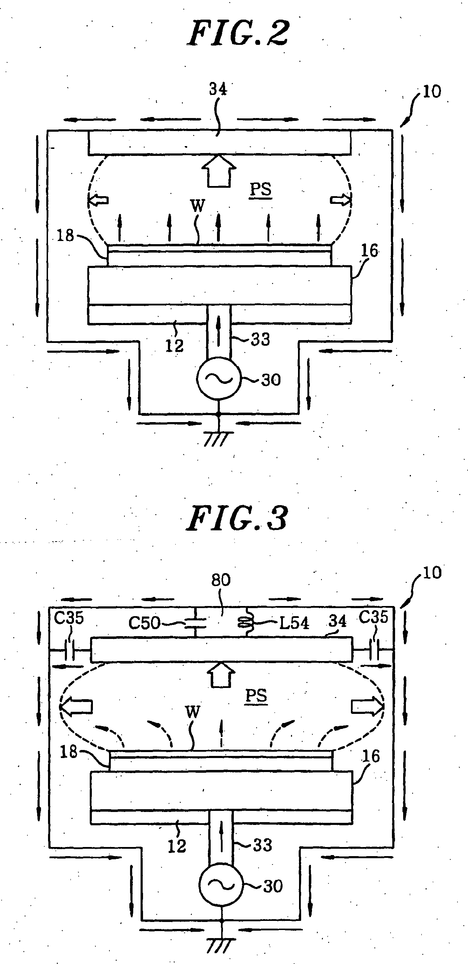

Hereinafter, examples and embodiments will be described with reference to the accompanying drawings.

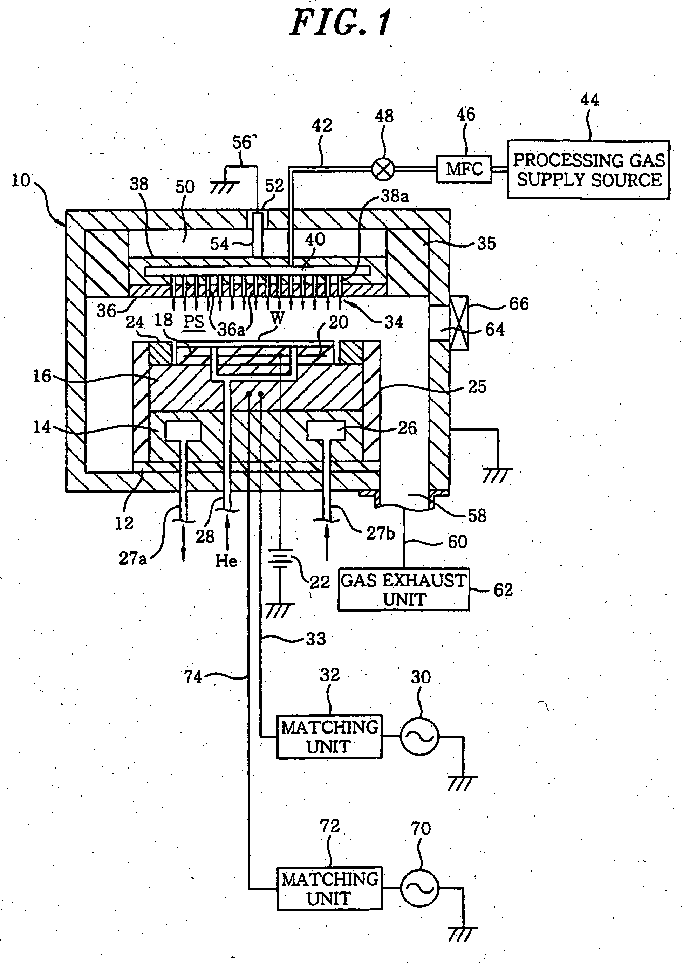

Fig. 1 illustrates a configuration of a plasma processing apparatus in accordance with an example. The plasma processing apparatus is configured as a capacitively coupled (parallel plate type) plasma processing apparatus of a type in which dual frequency powers are applied to a lower electrode. The plasma processing apparatus has a cylindrical vacuum chamber (processing chamber) 10 made of, e.g., an aluminum whose surface is alumite-treated (anodically oxidized), and the chamber 10 is frame grounded.
A cylindrical susceptor support 14 is provided at a bottom portion in the chamber 10 via an insulation plate 12 made of ceramic or the like. Further, a susceptor 16 made of, e.g., aluminum, is disposed above the susceptor support 14. The susceptor 16 serves as a lower electrode and a target substrate, e.g., a semiconductor wafer W, is mounted thereon.
On the top surface of the susceptor 16, there is disposed an electrostatic chuck 18 for attracting and holding the semiconductor wafer with an electrostatic adsorptive force. The electrostatic chuck 18 includes an electrode 20 formed of a conductive film which is inserted between a pair of insulating layers or sheets. A DC power supply 22 is connected to the electrode 20. The electrostatic chuck 18 is allowed to attract and hold the semiconductor wafer W thereon with a Coulomb force generated by a DC voltage applied from the DC power supply 22 thereto. A focus ring 24 made of, e.g., silicon is disposed to surround the electrostatic chuck 18 to improve an etching uniformity. Further, an inner wall member 25 made of, e.g., quartz is attached to the side surfaces of the susceptor 16 and the susceptor support 14.
A coolant path 26 is circumferentially provided inside the susceptor support 14. A coolant, e.g., cooling water, of a specific temperature is supplied into and circulated along the coolant path 26 from an external chiller unit (not shown) via coolant lines 27a, 27b. Accordingly, the processing temperature of the semiconductor wafer W on the susceptor 16 can be controlled by the temperature of the coolant. Further, a thermally conductive gas, e.g., He gas, is supplied into a gap between the top surface of the electrostatic chuck and the backside of the semiconductor wafer W from a thermally conductive gas supply unit (not shown) via a gas supply line 28.
The susceptor 16 is electrically connected with a first and a second radio frequency power supply 30 and 70 via matching units 32 and 72 and power feed rods 33 and 74, respectively. The first radio frequency power supply 30 outputs a radio frequency power of a specific frequency, e.g., 40 MHz, for plasma generation. Meanwhile, the second radio frequency power supply 70 outputs a radio frequency power of a specific frequency, e.g., 2 MHz, which mainly contributes to ion attraction toward the semiconductor wafer W on the susceptor and to prevention of an adhesion of an undesired film such as a deposited film, an oxide film or the like to an upper electrode 34 and removal of the undesired film which will be described later.
The upper electrode 34 is provided above the susceptor 16 to face the susceptor 16 in parallel. Further, the upper electrode 34 has an electrode plate 36 having a plurality of gas injection openings 36a and an electrode support 38 for detachably holding the electrode plate 36, the electrode plate 36 being made of a semiconductor material, e.g., Si, SiC or the like, the electrode support 38 being made of a conductive material, e.g., aluminum whose surface is alumite-treated. The upper electrode 34 is attached in an electrically floating state to the chamber 10 via a ring-shaped insulator 35. A plasma generation space or a processing space PS is defined by the upper electrode 34, the susceptor 16 and the sidewall of the chamber 10. The ring-shaped insulator 35, which is made of, e.g., alumina (Al₂O₃), is attached so that a gap between an outer peripheral surface of the upper electrode 34 and the sidewall of the chamber 10 can be airtightly sealed. The ring-shaped insulator 35 physically holds the upper electrode 34 and electrically forms a part of capacitance between the upper electrode 34 and the chamber 10.
The electrode support 38 has therein a gas buffer space 40 and also has on its bottom surface a plurality of gas ventholes 38a extending from the gas buffer space 40 to communicate with the gas injection openings 36a of the electrode plate 36. The gas buffer space 40 is connected with a processing gas supply source 44 via a gas supply line 42, and a mass flow controller MFC 46 and an opening/closing valve 48 are provided in the gas supply line 42. When a specific processing gas is introduced from the processing gas supply source 44 into the gas buffer space 40, the processing gas is injected into the processing space PS toward the semiconductor wafer W on the susceptor 16 in a shower shape from the gas injection openings 36a of the electrode plate 36. So, the upper electrode 34 also serves as a shower head for supplying a processing gas into the processing space PS.
Further, the electrode support 38 has therein a passageway (not shown) through which a coolant, e.g., cooling water, flows, so that a temperature of the entire upper electrode 34, particularly the electrode plate 36, can be controlled to a specific level with the coolant supplied from an external chiller unit. In order to further stabilize the temperature control of the upper electrode 34, a heater (not shown) including, e.g., a resistance heating element may be attached to an inside or a top surface of the electrode support 39.
A hollow space or gap 50 is provided between the top surface of the upper electrode 34 and the ceiling of the chamber 10. Further, a through-hole 52 is formed in a central portion of the top surface of the chamber 10, and a rod-shaped inductor 54 is vertically extended in the gap 50 and the through-hole 52. The rod-shaped inductor 54 has a lower end directly connected with the central portion of the top surface of the upper electrode 34 and an upper end connected with a ground potential (generally, the chamber 10) via a conducting wire. Alternatively, the upper end of the rod-shaped inductor 54 may be directly connected to the ceiling of the upper electrode 34.
An annular space defined by the susceptor 16, the susceptor support 14 and the sidewall of the chamber 10 serves as a gas exhaust space. A gas exhaust port 58 of the chamber 10 is provided at a bottom of the gas exhaust space. A gas exhaust unit 62 is connected with the gas exhaust port 58 via a gas exhaust line 60. The gas exhaust unit 62 has a vacuum pump such as a turbo molecular pump or the like, so that the inside of the chamber 10, especially the processing space PS, can be depressurized to a required vacuum level. Moreover, attached to the sidewall of the chamber 10 is a gate valve 66 for opening and closing a loading/unloading port 64 for the semiconductor wafer W.
In the plasma etching apparatus, in order to perform an etching process, the gate valve 66 is opened and a semiconductor wafer W to be processed is loaded into the chamber 10 to be mounted on the electrostatic chuck 18. Then, a specific processing gas, i.e., an etching gas (generally, a gaseous mixture) is supplied into the chamber 10 from the processing gas supply source 44 at a specified flow rate and flow rate ratio, while the chamber 10 is evacuated by the gas exhaust unit 62 such that the internal pressure of the chamber 10 is maintained at a specific vacuum level. Further, a first radio frequency power (about 2 MHz) and a second radio frequency power (about 40 MHz) are concurrently applied to the susceptor 16 from the first and the second radio frequency power supply 30, 70, respectively. Further, a DC voltage is applied to the electrode 20 of the electrostatic chuck 18 from the DC power supply 46, whereby the semiconductor wafer W is firmly fixed on the electrostatic chuck 18. The etching gas injected from the upper electrode 34 as the shower head is converted into a plasma by a radio frequency discharge in the plasma space PS, and films formed on the main surface of the semiconductor wafer W are etched by radicals or ions present in the plasma.
In such a capacitively coupled plasma etching apparatus, by applying to the susceptor (lower electrode) 16 a first radio frequency power of a relatively radio frequency, e.g., 40 MHz, suitable for plasma generation, a high-density plasma in a desirable dissociated state can be generated even at a low pressure. Also, by applying to the susceptor 16 a second radio frequency power of a relatively low frequency, e.g., 2 MHz, suitable for ion attraction, it is possible to perform an anisotropic etching having high selectivity to the semiconductor wafer W on the electrostatic chuck 18. Further, it is also possible to remove a deposited film or an oxide film on the upper electrode 34 (electrode surface cleaning) by the ions incident thereon or the sputtering.
Hereinafter, features of the plasma etching apparatus in accordance with the example will be described with reference to Figs. 2 to 4. For convenience, the second radio frequency power 70 that is substantially not related to the plasma generation and the control of a plasma spatial distribution is omitted in Figs. 2 and 3.
As described above, in the plasma etching apparatus, the upper electrode 34 is attached to the chamber 10 via the ring-shaped insulator 35 and the rod-shaped inductor 54 is connected between the upper electrode 34 and the ground potential. In other words, if the inductor 54 is detached, the upper electrode 34 is installed inside the processing chamber 10 in a DC-floating state.
First of all, as for a comparative example, there will be described a case where the upper electrode 34 is directly attached to the chamber 10 to be DC-connected with the ground potential, for example. In this case, as shown in Fig. 2, when the first radio frequency power from the radio frequency power supply 30 is applied to the susceptor 16, a plasma of the processing gas is generated in the processing space PS by a radio frequency discharge between the susceptor 16 and the upper electrode 34 and that between the susceptor 16 and the sidewall of the chamber 10. The plasma thus generated is diffused in all directions, especially in upward and radially outward directions. Electron current in the plasma flows toward the ground via the upper electrode 34, the sidewall of the chamber 10 or the like. In the susceptor 16, as the frequency of the first radio frequency power increases, a radio frequency current is likely to be gathered at the central portion of the susceptor due to skin effect and the susceptor 16 is closer to the upper electrode 34 than the sidewall of the chamber 10, the upper electrode 34 and the sidewall of the chamber 10 having a same potential (ground potential). Accordingly, a larger amount of radio frequency power is discharged from the central portion of the electrode toward the processing space PS. Thus, most of the plasma electron current flows in the upper electrode 34, especially in the central portion thereof, while a considerably small part of the plasma electron current flows in the sidewall of the chamber 10. As a result, the plasma density spatial distribution in the central portion of the electrode is highest and significantly different from that in the edge portion of the electrode.
In contrast, in the example of figure 1 in which the upper electrode 34 is attached to the chamber 10 in a DC-floating state and connected with the ground potential via the rod-shaped inductor 54, an equivalent circuit for a radio frequency transmission line from a boundary surface between the processing space PS and the upper electrode 34 to the ground potential via the upper electrode 34 is represented by a circuit including a coil L₅₄ arranged parallel to capacitors C₃₅ and C₅₀ as shown in Fig. 3. The coil L₅₄ is an inductance of the rod-shaped inductor 5 and 4 and specifically, the coil L₅₄ is connected in series with a resistance (not illustrated) of the rod-shaped inductor 54. The capacitor C₃₅ is a capacitance between the upper electrode 34 and the sidewall of the chamber 10 and mainly formed by the ring-shaped insulator 35. The capacitor C₅₀ is a capacitance between the upper electrode 34 and the ceiling of the chamber 10 and mainly formed by air in the gap 50.
In this case as well, as similarly to the case shown in Fig. 2, when the first radio frequency power from the radio frequency power supply 30 is applied to the susceptor 16, the plasma of the processing gas is generated in the processing space PS by a radio frequency discharge between the susceptor 16 and the upper electrode 34 and that between the susceptor 16 and the sidewall of the chamber 10. The plasma thus generated is diffused in upward and radially outward directions, and an electron current in the plasma flows toward the ground via the upper electrode 34, the sidewall of the chamber 10 or the like. In the susceptor 16, a radio frequency current is likely to be gathered at the central portion of the susceptor. Also, the susceptor 16 is located closer to the upper electrode 34 than the sidewall of the chamber 10. However, a parallel LC circuit 80 including the coil L₅₄ and the capacitors C₃₅ and C₅₀ is provided between the upper electrode 34 and the ground potential. Therefore, when the parallel LC circuit 80 provides a high impedance Z against the first radio frequency power, the radio frequency current hardly flows in the upper electrode 34 disposed directly above the susceptor 16 even though it is gathered at the central portion of the susceptor 16. Accordingly, a relatively increased part of the plasma electron current flows in the sidewall of the chamber 10, which makes the plasma density distribution widen radially. Theoretically, depending on the impedance Z of the parallel LC circuit 80, it is possible to control a ratio of the electron current flowing between the susceptor 16 and the upper electrode 34 and that flowing between the susceptor 16 and the sidewall of the chamber 10 and further to control the plasma density spatial distribution characteristics to be uniform in a diametric direction.

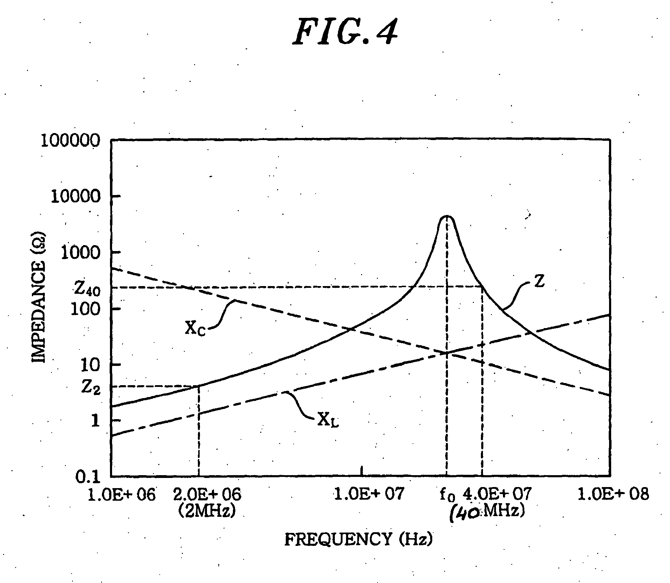

Fig. 4 describes an example of frequency-impedance characteristics for a radio frequency transmission line from the boundary surface between the processing space PS and the upper electrode 34 to the ground potential via the upper electrode in the plasma etching apparatus. In Fig. 4, an impedance X_{L} that gradually increases with respect to the frequency is an organic reactance |*jωL*₅₄| of the coil L₅₄, and an impedance X_{c} that gradually decreases with respect to the frequency is a capacitive reactance |1/*j*ω(C₃₅ +C₅₀)| of the capacitors C₃₅ and C₅₀- Theoretically, the parallel LC circuit 80 causes a parallel resonance or an antiresonance at a frequency where the organic reactance X_{L} becomes equal (absolute value) to the capacitive reactance X_{c}. Further, as shown in Fig. 4, an impedance Z of the parallel LC circuit 80 has a maximum peak value at the antiresonance frequency f₀. It is preferable that the antiresonance frequency f₀ appears within a range including the frequency of the first radio frequency power (preferably, from 5 MHz to 200 MHz).
Accordingly, as illustrated in Fig. 4, by selecting or setting a variable or selectable parameter, i.e., an inductance of the inductor 54 such that the antiresonance frequency f₀ appears near (preferably, at) the frequency (40 MHz) of the first radio frequency power, a high value Z₄₀ can be selected as the impedance Z of the parallel LC circuit 80 for the first radio frequency.
Further, as shown in Fig. 4, it is important that an impedance Z₈₀ of the parallel LC circuit 80 for the second radio frequency can be set to be a value Z₂ significantly smaller than the value Z₄₀ for the first radio frequency by setting the antiresonance frequency f₀ within the range from 5 MHz to 200 MHz. In other words, the upper electrode 34 can be grounded at a low impedance for the second radio frequency. As a consequence, the ions in the plasma which vibrate due to the second radio frequency are incident on the electrode plate 36 of the upper electrode 34 with a strong impact, thereby sputtering (removing) a deposited film or an oxide film attached on the surface of the electrode plate 36.

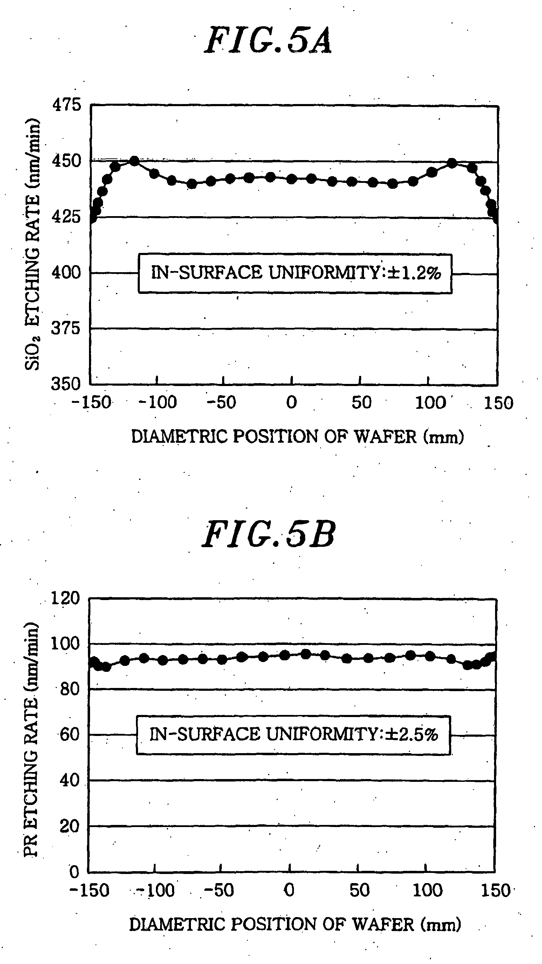

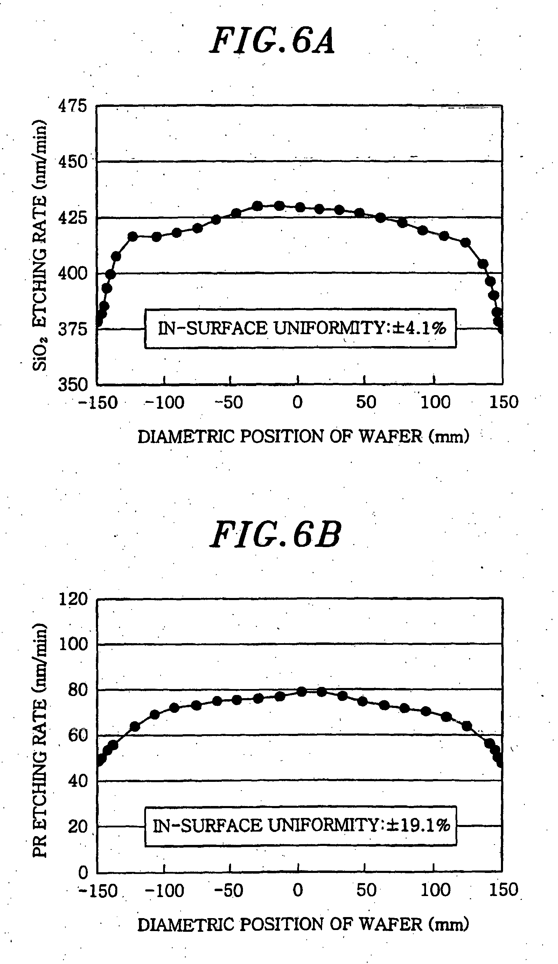

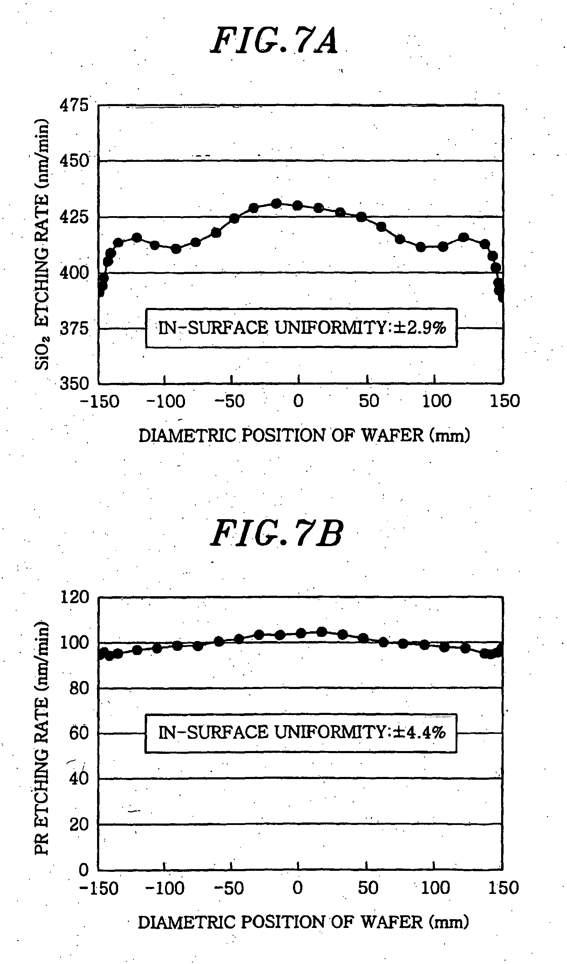

Figs. 5A and 5B illustrate, as a test example, in-surface distribution characteristics of etching rates of an oxide film SiO₂ and a photoresist PR by using the plasma etching apparatus of the first embodiment, respectively. In this test example, an inductance of the inductor 54 is set to be about 400 nH and a combined capacitance of the capacitors C₃₅ and C₅₀ is set to be about 250 pF (low capacitance). Meanwhile, Figs. 6A, 6B and 7A, 7B present comparative examples. Referring to Figs. 6A and 6B, there are illustrated, as a first comparative example, spatial distribution characteristics of the etching rates of the oxide film and the photoresist, respectively. In the first comparative example; the inductor 54 is omitted and a combined capacitance of the capacitors C₃₅ and C₅₀ is set to be about 20000 pH (high capacitance). Further, referring to Figs. 7A and 7B, there are illustrated, as a second comparative example, spatial distribution characteristics of the etching rates of the oxide film and the PR, respectively. In the second comparative example, the inductor 54 is omitted and a combined capacitance of the capacitors C₃₅ and C₅₀ is set to be about 250 pH (low capacitance). The test example and the comparative examples have the following common etching conditions.
Wafer diameter: 300 mm
Flow rates of processing gases:
C₄F₆/C₄F₈/Ar/O₂ = 40/20/500/60 sccm
Pressure in chamber: 30 mTorr
Radio frequency power: 40 MHz/2 MHz = 2500/3200 W
Temperature of upper electrode: 60 °C

As can be seen from Figs. 6A and 6B, in the first comparative example where the inductor 54 is omitted and a ground capacitance of the upper electrode 34 is set to be a high capacitance of about 20000 pF, the etching rates of the oxide film and the PR are relatively uniform in a central portion of the wafer. However, the etching rates thereof abruptly decrease near an edge portion of the wafer (R = ± 120 mm), which results in poor in-surface uniformity of ± 4.1 % and ± 19.1 %.
Meanwhile, as shown in Figs. 7A and 7B, the second comparative example where the inductor 54 is omitted and a ground capacitance of the upper electrode 34 is set to be a low capacitance of about 250 pF have significantly improved processing uniformity compared with the first comparative example. Specifically, the etching rate of the oxide film in the central portion of the wafer is substantially same as that of the first comparative example, and the etching rate of the oxide film in the edge portion of the wafer increases compared with that of the first comparative example, which leads to improved in-surface uniformity of ± 2.4 %. Moreover, the etching rate of the photoresist increases compared with that of the first comparative example and becomes uniform in each portion of the wafer, which results in improved in-surface uniformity of ± 4.4 %.
On the other hand, the test example has further improved processing uniformity compared with the second comparative example, as can be seen from Figs. 5A and 5B. Specifically, the etching rate of the oxide film increases in each portion of the wafer, especially in the edge portion, compared with that of the second comparative example, which results in significantly improved in-surface uniformity of ± 1.2 %. Further, the etching rate of the photoresist is substantially uniform in each portion of the wafer, which leads to improved in-surface uniformity of ± 2.5 %.
In general, the etching rate distribution of the oxide film reflects an electron density distribution in plasma, i.e., a plasma density distribution. Further, the etching rate distribution of the photoresist is affected by a dissociation of an initial gas by the plasma and thus more strongly depends on the plasma density distribution. Therefore, as can be seen from the test result of Figs. 5A and 5B, in accordance with the test example, the uniformity of the plasma density distribution is significantly improved by suppressing a concentration of the plasma generated in the processing space PS on the central portion of the electrode and broadening the plasma radially outwardly.
As described above, the plasma density distribution can be considerably improved in the second comparative example compared with the first comparative example. However, in the second comparative example in which the inductor 54 is not provided, the low-capacitance (250 pF) capacitors C₃₅ and C₅₀ forming the ground circuit of the upper electrode 34 provide a considerably great impedance to the second radio frequency (2 MHz) as well as the first radio frequency (40 MHz). More specifically, referring to Fig. 4 illustrating the frequency characteristics of the capacitive reactance X_{C}, the impedance at the first radio frequency (40 MHz) is higher than that at the second radio frequency (2 MHz). When the impedance of the ground circuit of the upper electrode 34 is high for the second radio frequency, the impact of ions incident on the upper electrode 34 due to the second radio frequency becomes weak, thereby deteriorating the sputtering effect.
To that end, in the test example, the inductor 54 is provided, so that an impedance of the parallel LC circuit 80 can be set to be high for the first radio frequency (40 MHz) and considerably low for the second radio frequency (2 MHz). Accordingly, the uniformity of the plasma density distribution can be significantly improved. Also, it is possible to maintain the impact intensity of ions incident on the upper electrode 34 and further the sputtering effect (electrode surface cleaning effects) sufficiently high.
As a result of measuring deposition rates of deposited films on a surface of the upper electrode 34 by using as an etching gas C₄F₈ gas generating a large amount of polymer in the test example and the second comparative example, the deposition rates of 80 nm/5 min and -100 nm/5 min were obtained in the test example and the second comparative example, respectively. In this measurement, the main etching conditions were as follows:
Flow rates of processing gases: C₄F₆/Ar = 5/1000 sccm
Pressure in chamber: 40 mTorr
Radio frequency power: 40 MHz/2 MHz = 2000/400 W
Temperature: upper electrode/chamber sidewall/lower electrode = 150/150/40 °C
Etching time: 5 min

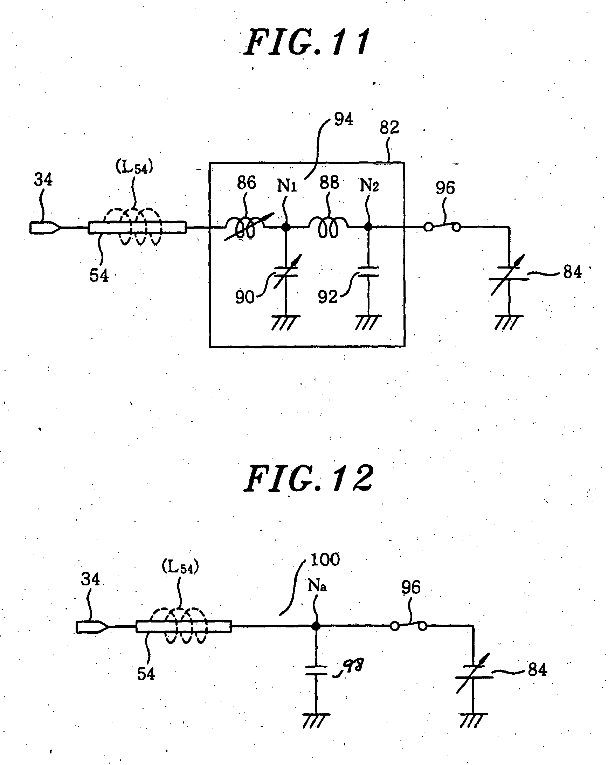

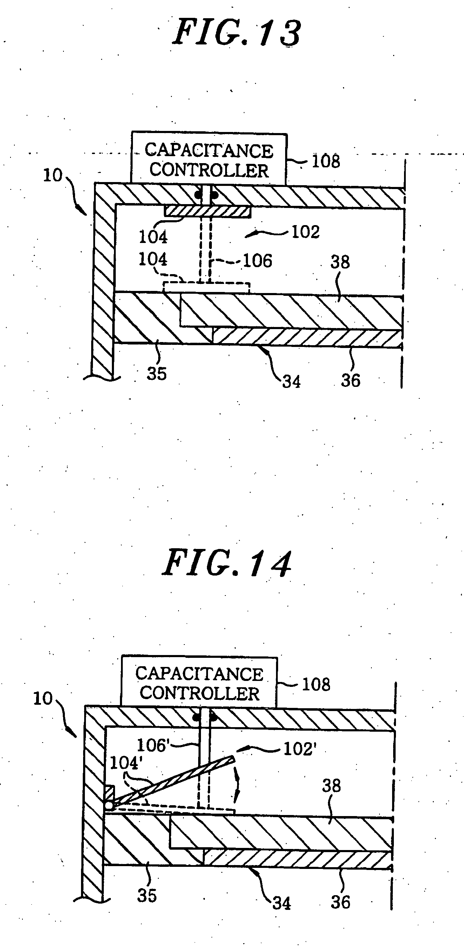

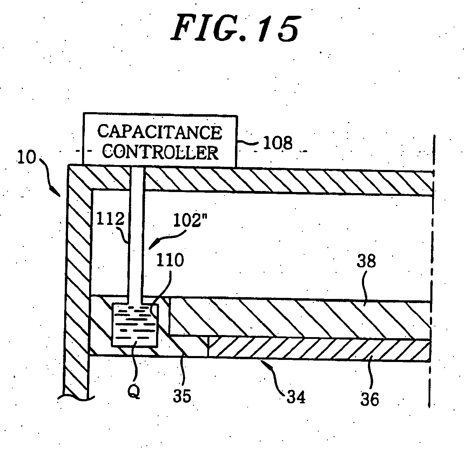

Consequently, it has been found that the deposited film is accumulated on the surface of the upper electrode 34 in the second comparative example, whereas it is efficiently removed therefrom in the etching mode in the test example.

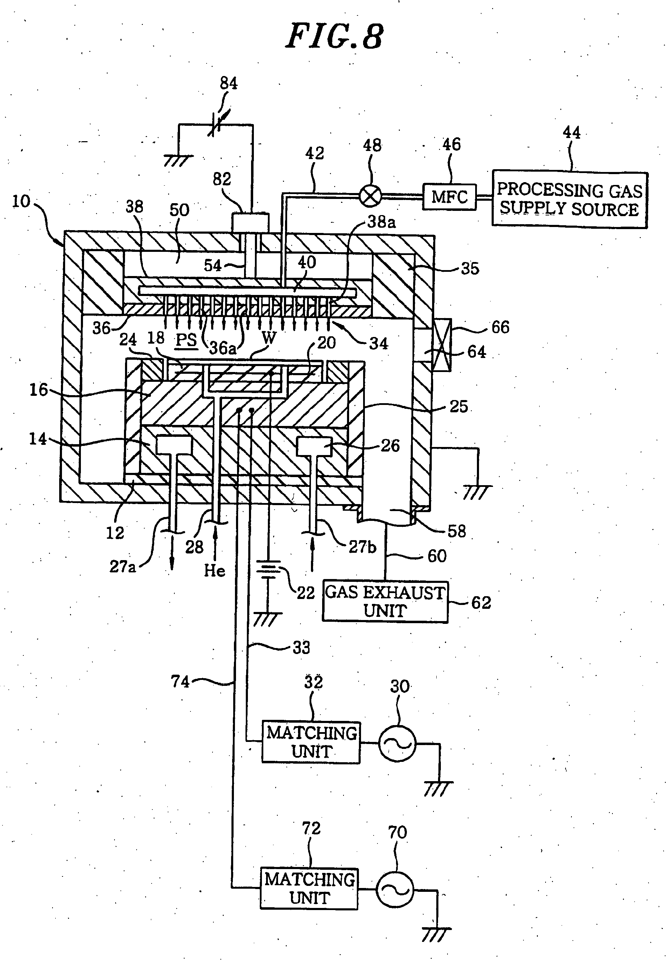

Fig. 8 illustrates a configuration of a plasma etching apparatus in accordance with an embodiment of the present invention. The upper end of the inductor 54 is electrically connected with a variable DC power supply 84 via a DC filter unit 82 in the embodiment, while it is grounded via the conducting wire 56 in the example of figure 1. The configurations and functions of the other components of the embodiment are same as those of the example of figure 1.

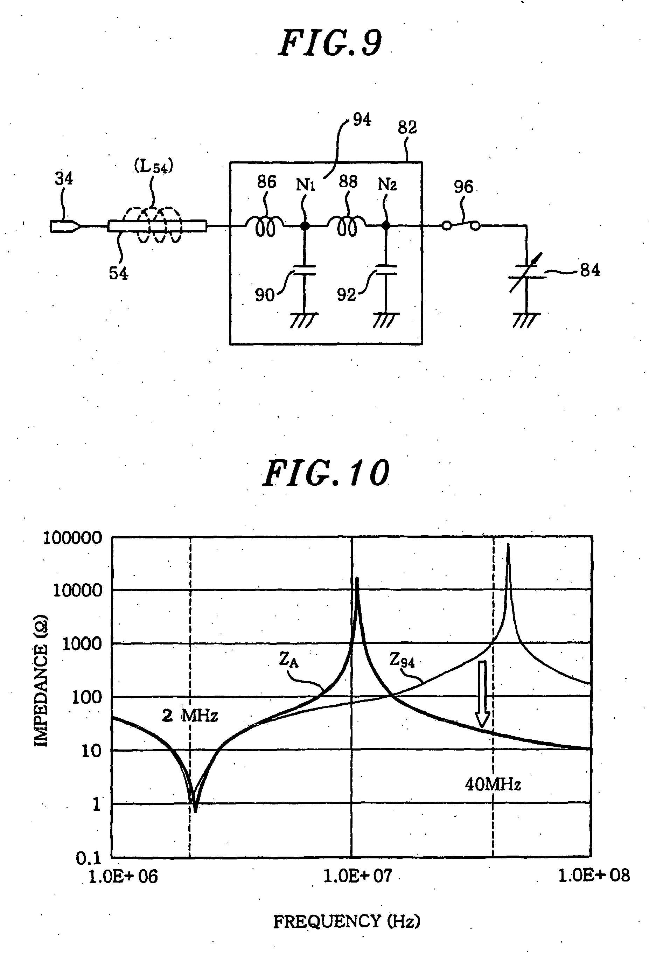

Fig. 9 shows an exemplary circuit configuration in the DC filter unit 82. In the DC filter unit 82 of this embodiment, the inductor 54 is connected in series with two coils 86 and 88 in a DC transmission line from the variable DC power supply 84 to the upper electrode 34. Further, capacitors 90 and 92 are respectively connected between a node N₁ and a ground potential and between a node N₂ and the ground potential, wherein the node N₁ is provided between the coils 86 and 88 and the node N₂ is provided between the coil 88 and the variable DC power supply 84. A serial-parallel LC circuit 94 is formed by the coils 86 and 88 and the capacitors 90 and 92.
Moreover, the DC filter unit 82 may have therein a cooling (blowing) device such as a fan so as to maintain the temperatures of electrical components or devices in the DC filter unit 82 at appropriate levels. Although the DC filter unit 82 can be installed at any location between the inductor 54 and the variable DC power supply 84, it is preferable that the DC filter unit 82 is mounted on a ceiling (top surface) of the chamber 10.
A DC voltage outputted from the variable DC power supply 84 is applied to the upper electrode 34 via the coils 86 and 88 of the serial-parallel LC circuit 94 and the inductor 54. Meanwhile, when the first and the second radio frequency power applied from the respective radio frequency power supplies 30 and 70 to the susceptor 16 are introduced to the upper electrode 34 via the processing space PS, they flow to the ground via the inductor 54 and the serial-parallel LC circuit 94 in the DC filter unit 82 while hardly flowing to the variable DC power supply 84.
The variable DC power supply 84 is configured to output a DC voltage having a polarity and a voltage level selected depending on processing types or conditions. It has been known that, by applying a proper DC voltage to the upper electrode 34, at least one of following effects can be obtained: (1) sputtering effect (deposit removal effect) on the upper electrode 34 is enhanced by increasing an absolute value of a self-bias voltage of the upper electrode 34; (2) the generation amount of plasma is reduced by enlarging a plasma sheath with respect to the upper electrode 34; (3) electrons generated near the upper electrode 34 are irradiated onto a target substrate (semiconductor wafer W); (4) a plasma potential can be controlled; (5) electron density (plasma density) is increased; and (6) the plasma density in the central portion is increased. For a case where it is not required to apply a DC voltage to be applied to the upper electrode 34, it is preferable to provide an on/off switch 96 including, e.g., a relay switch between the variable DC power supply 84 and the serial-parallel LC circuit 94.
In the embodiment, the serial-parallel LC circuit 94 in the DC filter unit 82 allows the DC voltage from the variable DC power supply 84 to flow therethrough to the upper electrode 34 and generates a serial resonance at a low frequency range (preferably, from 100 kHz to 15 MHz) and a parallel resonance at a radio frequency range (preferably, from 5 MHz to 200 MHz) with respect to the radio frequency from the upper electrode 34. By utilizing such frequency-impedance characteristics of the serial-parallel LC circuit 94, it is possible to further improve the individual functions of the first and the second radio frequency in the dual frequency application type wherein two radio frequency powers are applied to the lower electrode.
Fig. 10 depicts, as an example, frequency-impedance characteristics Z₉₄ of the serial-parallel LC circuit 94 alone in this embodiment and frequency-impedance characteristics Z_{A} in a radio frequency transmission line from a boundary surface between the processing space PS and the upper electrode 34 to the ground potential via the upper electrode 34.
As shown in Fig. 10, in this example, a resonance frequency and an antiresonance frequency of the serial-parallel LC circuit 94 are set to be about 2 MHz and about 45 MHz, respectively. In the frequency-impedance characteristics Z₉₄, a considerably high impedance of about 1000 Ω corresponds to the first radio frequency (40 MHz), whereas an extremely low impedance of about 1 Ω corresponds to the second radio frequency (2 MHz). In the frequency-impedance characteristics Z_{A} of the entire ground circuit around the upper electrode 34 wherein the inductor 54, the capacitors C₃₅, C₅₀ and the like are added to the serial-parallel LC circuit 94, the antiresonance frequency is shifted to the low frequency range up to about 10 MHz, whereas the resonance frequency is maintained near about 2 MHz. Further, while the impedance corresponding to the first radio frequency (40 MHz) is considerably reduced to about 20 Ω, the impedance corresponding to the second radio frequency (2 MHz) is slightly reduced to about 0.7 Ω, and the difference therebetween is still maintained more than 20 times.
A noticeable point in Fig. 10 is that the impedance corresponding to the second radio frequency (2 MHz) in the frequency-impedance characteristics Z_{A} of the entire ground circuit around the upper electrode 34 can be lowered to 1 Ω or less by utilizing a resonance phenomenon of the serial-parallel LC circuit 94. As a consequence, the upper electrode 34 is seemingly short-circuited to the ground potential (imaginary short-circuit state) in view of the second radio frequency (2 MHz), which enhances the impact intensity of ions incident on the upper electrode 34 due to the vibrations of the second radio frequency and further the sputtering effect (deposit removal effect).
The frequency-impedance characteristics Z₉₄ and Z_{A} shown in Fig. 10 are provided for illustrative purpose only and can be modified or adjusted by varying inductance values of the coils 86 and 88 and capacitance values of the capacitors 90 and 92 in the serial-parallel LC circuit 94.
Further, the circuit configuration shown in Fig. 9 is provided for illustrative purpose only, and a modification can be made in or around the DC filter unit 82. For example, in the serial-parallel LC circuit 94, the number of coils and capacitors may be changed, the circuit network may be formed in T type, π type or the like without being limited to that shown in Fig. 9. Besides, a circuit element having a different function, e.g., a noise removing coil (not shown) or the like, may be inserted between the serial-parallel LC circuit 94 and the variable DC power supply 84.
Moreover, a variable impedance element may be provided in the DC filter unit 82. For example, as shown in Fig. 11, the coil 86 and the capacitors 90 may be made to serve as a variable reactor and a variable capacitor, respectively.
In an example, instead of the serial-parallel LC circuit 94, the upper electrode 34 may be grounded via a serial LC circuit 100 including the inductor 54 and a capacitor 98, as shown in Fig. 12. In this case, as an entire ground circuit around the upper electrode 34, i.e., as an equivalent circuit in a radio frequency transmission line from the boundary surface between the processing space PS and the upper electrode 34 to the ground potential via the upper electrode 34, there is formed a serial-parallel LC circuit (not shown) in which the capacitors C₃₅ and C₅₀ (see, Fig. 3) are connected with the serial LC circuit 100 in parallel. In the frequency-impedance characteristics of the serial-parallel LC circuit, as similar to that in Fig. 10, an inductance of the inductor 54 and a capacitance of the capacitor 98 is preferred to be set such that a desired resonance frequency and a desired antiresonance frequency higher than the resonance frequency are obtained in respective frequency ranges, and preferably such that the resonance frequency is obtained near the frequency of the second radio frequency power.
Further, in case the variable DC power supply 84 is used, an output terminal of the variable DC power supply 84 is preferably electrically connected with a node Nₐ provided between the inductor 54 and the capacitor 98, as shown in Fig. 12. Moreover, the variable DC power supply 84 may be omitted. In such a case, the inductor 54 and the capacitor 98 may be exchanged with respect to the upper electrode 34. In other words, the capacitor 98 may be connected in series between the upper electrode 34 and the inductor 54. The inductor 54 is not limited to a rod-shaped conductor and may be formed of a coil-shaped conductor or any inductive element or member for providing a capacitive impedance.
Further, it is possible to vary an electrostatic capacitance or a ground capacitance around the upper electrode 34 in the plasma etching apparatus of the above embodiments. Figs. 13 to 15 show exemplary configurations of a capacitance varying unit.
Capacitance varying units 102 and 102' shown in Figs. 13 and 14 respectively include conductive plates 104 and 104' movable between a first position where it contacts with or adjacent to a top surface of the upper electrode 34 and a second position upwardly spaced from the upper electrode 34; manipulating mechanisms 106 and 106' for vertically moving or displacing the conductive plates 104 and 104'; and a capacitance controller 108 for controlling a ground capacitance of the upper electrode 34 to a desired level by using the manipulating mechanisms 106 and 106'. The manipulating mechanism 106 of Fig. 13, which is grounded directly or via the chamber, is made of a conductive material, a material conductive to a radio frequency, or a material having a low impedance to a radio frequency. The manipulating mechanism 106' of Fig. 14 may be made of an insulating material. In such capacitance varying types, a ground capacitance of the upper electrode 34 can be varied depending on the height positions of the conductive plates 104 and 104'. The closer the conductive plates 104 and 104' are to the ceiling surface of the chamber 10, the smaller the ground capacitance of the upper electrode 34 becomes. On the contrary, the closer the conductive plates 104 and 104' are to the top surface of the upper electrode 34, the grater the ground capacitance of the upper electrode 34 becomes. To be extreme, it is possible to make the ground capacitance infinite by allowing the upper electrode 34 to be grounded via the conductive plates 104 and 104' contacted therewith.
A capacitance varying unit 102" shown in Fig. 15 includes an annular liquid chamber 110 formed in the ring-shaped insulator 35 provided between the upper electrode 34 and the sidewall of the chamber 10. A liquid Q having an appropriate dielectric constant (for example, an organic solvent such as Galden or the like) can be supplied from the outside of the chamber 10 into the liquid chamber 110 via a line 112 and removed therefrom. By changing the kind (dielectric constant) or the amount of the liquid Q, an electrostatic capacitance of the entire ring-shaped insulator 35 and further a ground capacitance of the upper electrode 34 can be varied.
Alternatively, a variable capacitor (not shown) may be connected between the upper electrode 34 and the chamber 10.

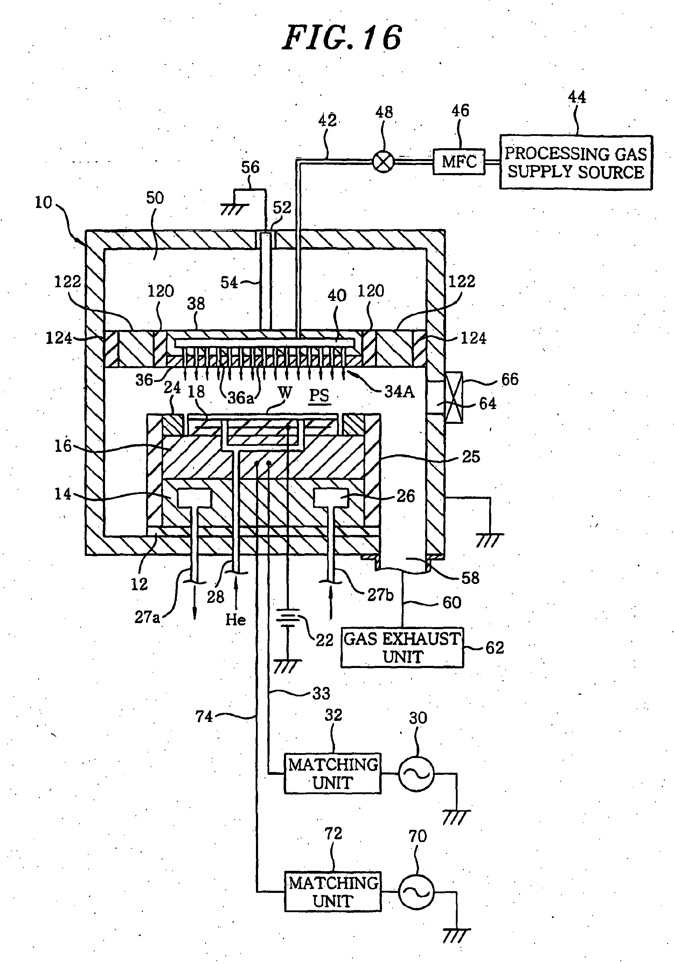

Any frequency-impedance characteristics can be realized by appropriately combining the variable capacitor, the capacitance varying unit 102, a variable inductance element (not shown) for varying an inductance of the inductor 54, the variable impedance element in the DC filter unit 82 shown in Fig. 11 and the like. More specifically, an impedance to the first radio frequency for plasma generation can be adjusted by the aforementioned variable capacitor or the capacitance varying unit 102, while an impedance to the second radio frequency for ion attraction can be adjusted by the variable impedance element in the DC filter unit 82.
As another example, a configuration shown in Fig. 16 may be employed. Specifically, the first radio frequency power is supplied from the radio frequency power supply 30 to the susceptor 16 via the matching unit 32 and the power feed rod 33 while the second radio frequency power is supplied from the radio frequency power supply 70 to the susceptor 16 via the matching unit 72 and the power feed rod 74 (the type in which dual frequency powers are applied to the lower electrode). Further, the upper electrode is divided in a radial direction into a disk-shaped inner upper electrode 34A and a ring-shaped outer upper electrode 122. A ring-shaped insulator 120 is inserted between the inner upper electrode 34A and the outer upper electrode 122 and, also, a ring-shaped insulator 124 is inserted between the outer upper electrode 122 and the sidewall of the chamber 10. Such a configuration enables the first radio frequency power of a radio frequency to flow mainly in a path to the sidewall (earth) of the chamber 10 via the outer upper electrode 122 and the second radio frequency power of a low frequency to flow mainly in a path to the earth via the inner upper electrode 34A and the power feed rod 52.
The frequencies of the first and the second radio frequency power are used as illustrative purpose only in the above embodiments, and any frequency can be selected depending on processes. In general, the first radio frequency power for plasma generation has a frequency of about 13.56 MHz or greater, and the second radio frequency power for ion attraction to the substrate or the upper electrode has a frequency of about 13.56 MHz or less.
The ground circuit around the upper electrode 34 in the aforementioned embodiments has been described for illustrative purpose only, and various modifications can be made to configurations and functions of the components of the apparatus. Although the above examples and embodiment have been described with respect to the plasma etching apparatus and method, the present disclosure may be applied to other parallel plate type plasma processing apparatus and method such as plasma chemical vapor deposition (CVD), plasma oxidation, plasma nitridation, sputtering and the like. Further, the substrate to be processed is not limited to the semiconductor wafer, but it may be a flat panel display substrate, a photo mask, a compact disk (CD) substrate, a printed substrate or the like. While the invention has been shown and described with respect to the embodiment, it will be understood by those skilled in the art that various changes and modification may be made without departing from the scope of the invention which is defined in the following claims.

## Claims

1. A plasma processing apparatus comprising:
an evacuable processing chamber (10) which is grounded;
a first electrode (34) attached to the processing chamber (10) via an insulating material or a space (50);
a second electrode (16) disposed in parallel with the first electrode (34) spaced apart therefrom in the processing chamber, the second electrode (16) being arranged to support a target substrate (W) to face the first electrode (34) ;
a first radio frequency power supply unit (30) arranged to apply a first radio frequency power of a first frequency to the second electrode (16);
a second radio frequency power supply unit (70) arranged to apply a second radio frequency power of a second frequency lower than the first frequency to the second electrode (16);
a processing gas supply unit (44) arranged to supply a processing gas to a processing space (PS) formed by the first and the second electrodes (34, 16) and a sidewall of the processing chamber (10); and
a DC power supply (84) arranged to apply a DC voltage to the first electrode (34);
a filter (82) electrically connected between the first electrode (34) and the DC power supply (84), the filter (82) allowing a direct current to substantially pass therethrough while having desired frequency-impedance characteristics for a radio frequency; **characterized in that**
the filter (82) has one or more inductors (86, 88) electrically connected in series in a DC transmission line between the first electrode (34) and the DC power supply (84); and one or more capacitors (90, 92) connected between a ground potential and one or more nodes (N₁, N₂) provided in the DC transmission line, and
the filter (82) is set such that in frequency-impedance characteristics of a radio frequency transmission line from a boundary surface between the processing space (PS) and the first electrode (34) to the ground potential via the first electrode (34), the frequency-impedance of the filter (82) makes an impedance corresponding to the second frequency lower than that corresponding to the first frequency.

2. The plasma processing apparatus of claim 1, wherein in the frequency-impedance characteristics, a resonance frequency is set within a range from about 100 kHz to about 15 MHz and an antiresonance frequency is set within a range from about 5 MHz to about 200 MHz.

3. The plasma processing apparatus of claim 2, wherein the frequency-impedance characteristics of the filter (82) are set to make the resonance frequency substantially equal or close to the second frequency.

4. The plasma processing apparatus of any one of claims 1 to 3, wherein frequency-impedance characteristics of the filter (82) are set to obtain desired plasma density distribution characteristics for a plasma generated in the processing space.

5. The plasma processing apparatus of any one of claims 1 to 4, wherein the first frequency is about 27 MHz or greater.

6. The plasma processing apparatus of claim 5, wherein the first frequency is about 40 MHz or greater.

7. The plasma processing apparatus of any one of claims 1 to 6, wherein the second frequency is about 13.56 MHz or less.

8. The plasma processing apparatus of any one of claims 1 to 7, wherein the first and the second electrodes (34, 16) serve as an upper and a lower electrode, respectively.

9. The plasma processing apparatus of claim 8, wherein a gas chamber (40) into which the processing gas from the processing gas supply unit (44) is introduced is provided above or at an upper portion of the first electrode (34), and a plurality of gas injection openings (36a) for injecting the processing gas from the gas chamber (40) into the processing space (PS) are formed in the first electrode (34).

10. The plasma processing apparatus of any one of claims 1 to 9, wherein a ring-shaped insulator (35) is airtightly provided between the first electrode (34) and the sidewall of the processing chamber (10).

11. A plasma processing method using the apparatus of claim 1 comprising the steps of:
disposing the first and the second electrode (34, 16) in parallel with a gap present therebetween in the evacuable processing chamber (10) which is grounded;
supporting a target substrate (W) on the second electrode (16) to face the first electrode (34);
vacuum exhausting an inside of the processing chamber (10) to a specific pressure level; and
supplying a processing gas into a processing space (PS) defined by the first and the second electrodes (34, 16) and a sidewall of the processing chamber (10) while applying to the second electrode (16) a first radio frequency power of a first frequency and a second radio frequency power of a second frequency lower than the first frequency; thereby generating a plasma from the processing gas in the processing space (PS) and performing a specified process on the target substrate (W) by using the plasma, applying a DC voltage with the DC power supply (84) to the first electrode (34),
setting the filter (82) such that in frequency-impedance characteristics of a radio frequency transmission line from a boundary surface between the processing space (PS) and the first electrode (34) to the ground potential via the first electrode, the frequency-impedance characteristics makes an impedance corresponding to the second frequency lower than that corresponding to the first frequency.

12. The plasma processing method of claim 11, wherein in the frequency-impedance characteristics, a serial resonance frequency is set within a range from 100 kHz to 15 MHz and a parallel resonance frequency is set within a range from 5 MHz to 200 MHz.

13. The plasma processing method of claim 11, wherein the frequency-impedance characteristics are set to make the resonance frequency be about the second frequency.

14. The plasma processing method of any one of claims 11 to 13, wherein the frequency-impedance characteristics are set to obtain desired plasma density distribution characteristics for the plasma generated in the processing space (PS).

## Patentansprüche

1. Plasma verarbeitende Vorrichtung, Folgendes umfassend:
eine evakuierbare Verarbeitungskammer (10), welche geerdet ist;
eine erste Elektrode (34), welche an der Verarbeitungskammer (10) über ein isolierendes Material oder einen Abstand (50) befestigt ist;
eine zweite Elektrode (16), welche parallel zu der ersten Elektrode (34) und von ihr beabstandet in der Verarbeitungskammer angeordnet ist, wobei die zweite Elektrode (16) angeordnet ist, um ein Zielsubstrat (W) gegenüber der ersten Elektrode (34) zu stützen;
eine erste Hochfrequenz-Stromversorgungseinheit (30), welche eingerichtet ist, eine erste Hochfrequenzleistung einer ersten Frequenz an die zweite Elektrode(16) anzulegen;
eine zweite Hochfrequenz-Stromversörgungseinheit (70), welche eingerichtet ist, eine zweite Hochfrequenzleistung einer zweiten Frequenz, welche niedriger ist als die erste Frequenz, an die zweite Elektrode(16) anzulegen;
eine Verarbeitungsgas-Versorgungseinheit (44), welche eingerichtet ist, ein Verarbeitungsgas an einen Verarbeitungsraum (VR) zu liefern, welcher von der ersten und der zweiten Elektrode (34, 16) und einer Seitenwand der Verarbeitungskammer (10) ausgebildet wird; und
eine Gleichstromversorgung (84), welche eingerichtet ist, eine Gleichspannung an die erste Elektrode (34) anzulegen;
einen Filter (82), welcher elektrisch zwischen der ersten Elektrode (34) und der Gleichstromversorgung (84) verbunden ist, wobei der Filter (82) einem Gleichstrom ermöglicht, im Wesentlichen durch ihn zu passieren, während er erwünschte Frequenzimpedanzeigenschaften für eine Hochfrequenz aufweist; **dadurch gekennzeichnet, dass**
der Filter (82) einen oder mehrere Induktoren (86, 88) aufweist, welche in einer Gleichstrom-Übertragungsleitung in Serie zwischen der ersten Elektrode (34) und der Gleichstromversorgung (84) elektrisch verbunden sind; und ein oder mehrere Kondensatoren (90, 92), welche zwischen einem Massepotenzial und einem oder mehreren Knoten (N₁, N₂) verbunden sind, welche in der Gleichstrom-Übertragungsleitung bereitgestellt sind, und
der Filter (82) derartig eingestellt ist, dass in Frequenzimpedanzeigenschaften einer Hochfrequenz-Übertragungsleitung von einer Begrenzungsfläche zwischen dem Verarbeitungsraum (VR) und der ersten Elektrode (34) an das Massepotenzial über die erste Elektrode (34), die Frequenzimpedanz des Filters (82) eine Impedanz ausmacht, welche der zweiten Frequenz entspricht und kleiner ist als diejenige, welche der ersten Frequenz entspricht.

2. Plasma verarbeitende Vorrichtung nach Anspruch 1, wobei in den Frequenzimpedanzeigenschaften eine Resonanzfrequenz innerhalb eines Bereichs von ungefähr 100 kHz bis ungefähr 15 MHz eingestellt ist und eine Antiresonanzfrequenz innerhalb eines Bereichs von ungefähr 5 MHz bis ungefähr 200 MHz eingestellt ist.

3. Plasma verarbeitende Vorrichtung nach Anspruch 2, wobei die Frequenzimpedanzeigenschaften des Filters (82) eingestellt sind, um die Resonanzfrequenz im Wesentlichen gleich der zweiten Frequenz oder nahe daran zu machen.

4. Plasma verarbeitende Vorrichtung nach einem der Ansprüche 1 bis 3, wobei Frequenzimpedanzeigenschaften des Filters (82) eingestellt sind, um erwünschte Plasmadichte-Verteilungseigenschaften für ein Plasma zu erhalten, welches in dem Verarbeitungsraum erzeugt wird.

5. Plasma verarbeitende Vorrichtung nach einem der Ansprüche 1 bis 4, wobei die erste Frequenz ungefähr 27 MHz oder mehr beträgt.

6. Plasma verarbeitende Vorrichtung nach Anspruch 5, wobei die erste Frequenz ungefähr 40 MHz oder mehr beträgt.

7. Plasma verarbeitende Vorrichtung nach einem der Ansprüche 1 bis 6, wobei die zweite Frequenz ungefähr 13,56 MHz oder weniger beträgt.

8. Plasma verarbeitende Vorrichtung nach einem der Ansprüche 1 bis 7, wobei die erste und die zweite Elektrode (34, 16) als eine obere bzw. eine untere Elektrode dienen.

9. Plasma verarbeitende Vorrichtung nach Anspruch 8, wobei eine Gaskammer (40), in welche das Verarbeitungsgas von der Verarbeitungsgas-Versorgungseinheit (44) eingeführt wird, über oder an einem oberen Abschnitt der ersten Elektrode (34) bereitgestellt ist, und mehrere Gasinjektionsöffnungen (36a) zum Injizieren des Verarbeitungsgases aus der Gaskammer (40) in den Verarbeitungsraum (VR) in der ersten Elektrode (34) ausgebildet sind.

10. Plasma verarbeitende Vorrichtung nach einem der Ansprüche 1 bis 9, wobei ein ringförmiger Isolator (35) luftdicht zwischen der ersten Elektrode (34) und der Seitenwand der Verarbeitungskammer (10) bereitgestellt ist.

11. Plasma verarbeitendes Verfahren, welches die Vorrichtung nach Anspruch 1 verwendet, die folgenden Schritte umfassend:
Anordnen der ersten und der zweiten Elektrode (34, 16) parallel zu einer Lücke, welche dazwischen in der evakuierbaren Verarbeitungskammer (10) vorhanden ist, welche geerdet ist;
Stützen eines Zielsubstrats (W) auf der zweiten Elektrode (16) gegenüber der ersten Elektrode (34);
Evakuieren eines Inneren der Verarbeitungskammer (10) auf einen spezifischen Druckpegel; und
Zuführen eines Verarbeitungsgases in einen Verarbeitungsraum (VR), welcher durch die erste und die zweite Elektrode (34, 16) und eine Seitenwand der Verarbeitungskammer (10) definiert ist, dabei Anlegen einer ersten Hochfrequenzleistung einer ersten Frequenz und einer zweiten Hochfrequenzleistung einer zweiten Frequenz, welche niedriger ist als die erste Frequenz, an die zweite Elektrode (16), dadurch Erzeugen eines Plasmas aus dem Verarbeitungsgas in dem Verarbeitungsraum (VR) und Durchführen eines spezifizierten Prozesses auf dem Zielsubstrat (W) unter Verwendung des Plasmas,
Anlegen einer Gleichspannung mit der Gleichstromversorgung (84) an die erste Elektrode (34),
Einstellen des Filters (82) derartig, dass in Frequenzimpedanzeigenschaften einer Hochfrequenz-Übertragungsleitung von einer Begrenzungsfläche zwischen dem Verarbeitungsraum (VR) und der ersten Elektrode (34) an das Massepotenzial über die erste Elektrode, die Frequenzimpedanzeigenschaften eine Impedanz ausmachen, welche der zweiten Frequenz entspricht und kleiner ist als diejenige, welche der ersten Frequenz entspricht.

12. Plasma verarbeitendes Verfahren nach Anspruch 11, wobei in den Frequenzimpedanzeigenschaften eine serielle Resonanzfrequenz innerhalb eines Bereichs von 100 kHz bis 15 MHz eingestellt ist und eine parallele Resonanzfrequenz innerhalb eines Bereichs von 5 MHz bis 200 MHz eingestellt ist.

13. Plasma verarbeitendes Verfahren nach Anspruch 11, wobei die Frequenzimpedanzeigenschaften eingestellt sind, um die Resonanzfrequenz ungefähr gleich der zweiten Frequenz zu machen.

14. Plasma verarbeitendes Verfahren nach einem der Ansprüche 11 bis 13, wobei Frequenzimpedanzeigenschaften eingestellt sind, um erwünschte Plasmadichte-Verteilungseigenschaften für das Plasma zu erhalten, welches in dem Verarbeitungsraum (VR) erzeugt wird.

## Revendications

1. Appareil de traitement au plasma comprenant :
une chambre de traitement sous vide (10) qui est mise à la terre ;
une première électrode (34) fixée à la chambre de traitement (10) via un matériau isolant ou un espace (50) ;
une deuxième électrode (16) disposée en parallèle avec la première électrode (34) espacée de celle-ci dans la chambre de traitement, la deuxième électrode (16) étant agencée de manière à supporter un substrat cible (W) pour faire face à la première électrode (34) ;
une première unité d'alimentation de radiofréquence (30) agencée de manière à appliquer une première puissance radiofréquence d'une première fréquence à la deuxième électrode (16) ;
une deuxième unité d'alimentation de radiofréquence (70) agencée de manière à appliquer une deuxième puissance radiofréquence d'une deuxième fréquence inférieure à la première fréquence à la deuxième électrode (16) ;
une unité d'alimentation en gaz de traitement (44) agencée de manière à alimenter un gaz de traitement à un espace de traitement (PS) formé par les première et deuxième électrodes (34, 16) et une paroi latérale de la chambre de traitement (10) ; et
un bloc d'alimentation en courant continu (84) agencé de manière à appliquer une tension de courant continu à la première électrode (34) ;
un filtre (82) connecté électriquement entre la première électrode (34) et le bloc d'alimentation en courant continu (84), le filtre (82) permettant à un courant continu de passer essentiellement à travers celui-ci tout en ayant des caractéristiques souhaitées de fréquence-impédance pour une radiofréquence ;
**caractérisé en ce que**
le filtre (82) a une ou plusieurs bobine(s) d'induction (86, 88) connectée (s) électriquement en série dans une ligne de transmission de courant continu entre la première électrode (34) et le bloc d'alimentation en courant continu (84) ; et un ou plusieurs condensateur(s) (90, 92) connecté(s) entre un potentiel de terre et un ou plusieurs noeud(s) (N₁, N₂) prévu(s) dans la ligne de transmission de courant continu, et
le filtre (82) est réglé de sorte que, dans les caractéristiques de fréquence-impédance d'une ligne de transmission de radiofréquence à partir d'une surface limite entre l'espace de traitement (PS) et la première électrode (34) au potentiel de terre via la première électrode (34), la fréquence-impédance du filtre (82) rende une impédance correspondant à la deuxième fréquence inférieure à celle correspondant à la première fréquence.

2. Appareil de traitement au plasma de la revendication 1, dans lequel, dans les caractéristiques de fréquence-impédance, une fréquence de résonance est réglée dans une plage allant d'environ 100 kHz à environ 15 MHz et une fréquence d'antirésonance est réglée dans une plage allant d'environ 5 MHz à environ 200 MHz.

3. Appareil de traitement au plasma de la revendication 2, dans lequel les caractéristiques de fréquence-impédance du filtre (82) sont définies de manière à rendre la fréquence de résonance essentiellement égale à la deuxième fréquence ou proche de celle-ci.

4. Appareil de traitement au plasma de l'une quelconque des revendications 1 à 3, dans lequel les caractéristiques de fréquence-impédance du filtre (82) sont définies de manière à obtenir des caractéristiques souhaitées de distribution de densité de plasma pour un plasma généré dans l'espace de traitement.

5. Appareil de traitement au plasma de l'une quelconque des revendications 1 à 4, dans lequel la première fréquence est d'environ 27 MHz ou plus.

6. Appareil de traitement au plasma de la revendication 5, dans lequel la première fréquence est d'environ 40 MHz ou plus.

7. Appareil de traitement au plasma de l'une quelconque des revendications 1 à 6, dans lequel la deuxième fréquence est d'environ 13,56 MHz ou moins.

8. Appareil de traitement au plasma de l'une quelconque des revendications 1 à 7, dans lequel les première et deuxième électrodes (34, 16) servent d'une électrode supérieure et d'une électrode inférieure, respectivement.

9. Appareil de traitement au plasma de la revendication 8, dans lequel une chambre à gaz (40), dans laquelle le gaz de traitement provenant de l'unité d'alimentation en gaz de traitement (44) est introduit, est prévue au-dessus ou au niveau d'une partie supérieure de la première électrode (34), et une pluralité d'ouvertures d'injection de gaz (36a) permettant d'injecter le gaz de traitement à partir de la chambre à gaz (40) dans l'espace de traitement (PS) sont formées dans la première électrode (34).

10. Appareil de traitement au plasma de l'une quelconque des revendications 1 à 9, dans lequel un isolateur annulaire (35) est prévu de manière étanche à l'air entre la première électrode (34) et la paroi latérale de la chambre de traitement (10).

11. Procédé de traitement au plasma utilisant l'appareil de la revendication 1, comprenant les étapes qui consistent :
à disposer les première et deuxième électrodes (34, 16) en parallèle avec un espace présent entre celles-ci dans la chambre de traitement sous vide (10) qui est mise à la terre ;
à supporter un substrat cible (W) sur la deuxième électrode (16) pour faire face à la première électrode (34) ;
à évacuer sous vide l'espace intérieur de la chambre de traitement (10) à un niveau de pression spécifique ; et
à alimenter un gaz de traitement dans un espace de traitement (PS) défini par les première et deuxième électrodes (34, 16) et une paroi latérale de la chambre de traitement (10) tout en appliquant à la deuxième électrode (16) une première puissance radiofréquence d'une première fréquence et une deuxième puissance radiofréquence d'une deuxième fréquence inférieure à la première fréquence ; générant ainsi un plasma à partir du gaz de traitement dans l'espace de traitement (PS) et à exécuter un processus spécifié sur le substrat cible (W) en utilisant le plasma,
à appliquer une tension de courant continu, avec le bloc d'alimentation en courant continu (84), à la première électrode (34),
à régler le filtre (82) de sorte que, dans les caractéristiques de fréquence-impédance d'une ligne de transmission de radiofréquence à partir d'une surface limite entre l'espace de traitement (PS) et la première électrode (34) au potentiel de terre via la première électrode, les caractéristiques de fréquence-impédance rendent une impédance correspondant à la deuxième fréquence inférieure à celle correspondant à la première fréquence.

12. Procédé de traitement au plasma de la revendication 11, dans lequel, dans les caractéristiques de fréquence-impédance, une fréquence de résonance en série est réglée dans une plage allant de 100 kHz à 15 MHz et une fréquence de résonance parallèle est réglée dans une plage allant de 5 MHz à 200 MHz.

13. Procédé de traitement au plasma de la revendication 11, dans lequel les caractéristiques de fréquence-impédance sont définies de manière à rendre la fréquence de résonance égale, à peu près, à la deuxième fréquence.

14. Procédé de traitement au plasma de l'une quelconque des revendications 11 à 13, dans lequel les caractéristiques de fréquence-impédance sont définies de manière à obtenir des caractéristiques souhaitées de distribution de densité de plasma pour le plasma généré dans l'espace de traitement (PS).
